# EUROPÄISCHE PATENTSCHRIFT

(11) **EP 1 473 764 B1**
(45) Veröffentlichungstag und Bekanntmachung des Hinweises auf die Patenterteilung: **14.05.2008**
(21) Anmeldenummer: 04100777.4
(22) Anmeldetag: 27.02.2004
(51) Int. Cl.: H01L 21/68, H01L 21/00

(54) **Multifunktion-Substratsträger**
Multifunction support for substrat
Support multifonctionnel pour substrat

(30) Priorität: 29.04.2003 DE 10319272
(43) Veröffentlichungstag der Anmeldung: 03.11.2004
(73) Patentinhaber: Infineon Technologies AG, 81669 München (DE)
(72) Erfinder: Matschitsch, Martin, 9181, Feistritz i. Ros (AT); von Koblinski, Carsten, 9500, Villach (AT)
(74) Vertreter: Kindermann, Peter

(56) Entgegenhaltungen:
- EP-A- 1 294 014
- EP-A1- 0 201 240
- EP-A2- 1 091 389
- WO-A-02/13244
- JP-A- 59 048 938
- US-A- 4 566 726
- US-A- 5 979 475

## Beschreibung

Die vorliegende Erfindung bezieht sich auf einen Multifunktionsträger sowie eine zugehörige Andockstation zur Realisierung einer lösbaren Verbindung zu einem Werkstück und insbesondere auf einen Multifunktionsträgerwafer zum Tragen bzw. Halten von ultradünnen verworfenen Produktwafern.

Derzeit werden Halbleiterbauelemente zunehmend auf sehr dünnen Halbleiterscheiben bzw. Wafern hergestellt, wobei sogenannte ultradünne Wafer bzw. ultradünne Produktwafer eine Dicke von weniger als 200 µm und insbesondere weniger als 50 µm aufweisen können. Hierzu werden üblicherweise Standard-Halbleiterwafer verwendet, die eine Standarddicke von 500 bis 700 µm aufweisen und die vor der Fertigstellung von jeweiligen Halbleiterbauelementen dünngeschliffen werden.

Solche ultradünnen Wafer sind jedoch auf Grund ihrer mechanischen Eigenschaften sehr schwierig handhabbar und lassen sich nicht mit den selben Fertigungsmaschinen und Transport- sowie Haltevorrichtungen bearbeiten wie die Wafer mit einer herkömmlichen Standarddicke. Darüber hinaus sind derartige ultradünne Wafer mit einer entsprechend strukturierten Vorderseite mehr oder weniger verbogen bzw. verworfen, wobei dieser sogenannte "Bow" bei 6-Zoll-Wafern bis zu 20 mm sowohl konkav als auch konvex sein kann. Da die Berührungsfläche zwischen diesem verbogenen Produktwafer und einem Greifer bzw. einer Haltevorrichtung nicht ausreichend ist, sind derartige herkömmliche Haltevorrichtungen üblicherweise nicht ausreichend.

Deshalb müssen eigens für ultradünne Produktwafer modifizierte Fertigungsmaschinen und Transportvorrichtungen hergestellt werden, die für spezielle Waferkassetten ausgelegt sind und die eigens für ultradünne Wafer konstruierte, üblicherweise manuell zu bedienende Greifvorrichtungen zur Bestückung der Fertigungsmaschinen aufweisen.

Ferner sind hierbei die Haltevorrichtungen zur Fixierung der ultradünnen Wafer während des eigentlichen Herstellungsprozesses, wie beispielsweise Chucks, mehr oder weniger aufwändig für die Erfordernisse des sogenannten ultradünnen verworfenen Produktwafers umgebaut. Darüber hinaus sind einer Modifizierung von Fertigungsmaschinen für die Zwecke der Bearbeitung und Handhabung ultradünner verworfener Wafer auf Grund ihrer zunehmenden Komplexität enge Grenzen gesetzt.

Die Bereitstellung derartiger neuer oder modifizierter Fertigungsmaschinen zur Bearbeitung ultradünner Wafer ist daher äußerst aufwendig und kostenintensiv.

Für Prozesse, bei denen keinerlei Temperaturbehandlungen auftreten, sind beispielsweise Verfahren bekannt, die ultradünnen Produktwafer mit einem Wachs oder einer zweiseitig klebenden Folie auf einem Trägerwafer befestigen, um sie nachher mittels einer Temperatureinwirkung wieder zu lösen.

Ferner sind Verfahren zur Herstellung einer Verbindung zwischen einem Produktwafer und einem Trägerwafer bekannt, die auch höheren Temperaturen standhalten. Nachteilig ist hierbei jedoch die Verwendung beispielsweise von alkoholisch gelösten Silikaten als Bindemittel, die insbesondere bei höheren Temperaturen die elektrischen Eigenschaften von auszubildenden Halbleiterbauelementen im Produktwafer beeinträchtigen können oder besonderer Ätzverfahren bedürfen.

Der Aufwand dieser herkömmlichen Verfahren ist jedoch relativ hoch, da insbesondere ein Verbrauch von Verschleißmaterialien und Opferschichten sowie für ganze Wafer die Kosten erhöhen.

Ferner sind oftmals eine Vielzahl von Reinigungsprozeduren nach der Trennung des Produktwafers von seinem Trägerwafer notwendig, die wiederum eine Gefahr von möglichem Bruch und verlängerte Prozess-Laufzeiten beinhalten.

Ferner sind zur Realisierung einer reversiblen bzw. lösbaren Verbindung sogenannte elektrostatische Haltevorrichtungen bzw. Chucks allgemein bekannt, wobei mittels elektrostatischer Anziehungskräfte eine lösbare Verbindung zu einem elektrisch leitenden Werkstück realisiert bzw. ein Halbleiterwafer elektrostatisch gehalten werden kann. Leider ergeben sich insbesondere beim Entfernen bzw. De-Chucken von ultradünnen Wafern Probleme bei derartigen herkömmlichen elektrostatischen Chucks, so wie sie eine außerordentliche Empfindlichkeit gegenüber Anätzungen aufweisen.

Darüber hinaus ist insbesondere auf Grund der auftretenden Verwerfungen bei ultradünnen Produktwafern eine Wirkungsweise der elektrostatischen Kräfte nur gering oder nicht vorhanden.

Ferner sind derartige herkömmliche elektrostatische Chucks lediglich begrenzt einsetzbar, da sie bei Herstellungsprozessen mit einer Ladungsbeaufschlagung, wie beispielsweise einer Implantation oder einem Plasmaätzen, ebenfalls ihre Wirkung verlieren.

Dokument EP 1091389 beschreibt ein Bernoulli und Vakuum-Kombigreifer zum Handhaben dünner Water.

Der Erfindung liegt daher die Aufgabe zu Grunde einen Multifunktionsträger sowie eine zugehörige Andockstation zur Realisierung einer lösbaren Verbindung zu einem beliebigen verworfenen Werkstück zu schaffen, wobei man eine maximale Flexibilität bei hervorragenden Halteeigenschaften erhält.

Erfindungsgemäß wird diese Aufgabe hinsichtlich des Multifunktionsträgers durch die Merkmale des Patentanspruchs 1 und hinsichtlich der Andockstation durch die Merkmale des Patentanspruchs 15 gelöst.

Insbesondere durch die Verwendung einer Bernoulli-Planarisiervorrichtung zum Planarisieren des Werkstücks auf dem Trägersubstrat nach dem Bernoulli-Prinzip, einer elektrostatischen Haltevorrichtung zum Halten des Werkstücks auf dem Trägersubstrat mittels elektrostatischer Kraft und einer Vakuum-Haltevorrichtung zum Halten des Werkstücks auf dem Trägersubstrat mittels Vakuumkraft, wobei die Planarisiervorrichtung und die Haltevorrichtungen Anschlusselemente zum lösbaren Anschließen an eine Andockstation aufweisen, erhält man einen hochflexiblen Support-Träger, der insbesondere für ultradünne verworfene Produktwafer eine effektive Weiterverwendbarkeit von bereits bestehenden Fertigungslinien und Herstellungsanlagen ermöglicht.

Vorzugsweise weisen die Anschlusselemente ein automatisches Verschlusssystem auf, wodurch nicht nur die Haltekräfte der Vakuum-Haltevorrichtung und der elektrostatischen Haltevorrichtung konserviert werden können, sondern auch ein Eindringen von beispielsweise Ätzmitteln zuverlässig verhindert werden kann.

Vorzugsweise wird die Bernoulli-Planarisiervorrichtung nicht nur zum Planarisieren des Werkstücks auf dem Trägersubstrat zu Beginn der Befestigung verwendet, sondern kann in einem späteren Herstellungsschritt auch als Kühlvorrichtung zum Kühlen des gehaltenen Werkstücks verwendet werden.

Neben dieser weiteren Funktionalität als Kühlvorrichtung kann die Bernoulli-Planarisiervorrichtung bzw. Teile davon auch als Haltekraft-Messvorrichtung zum Erfassen einer auf das Werkstück ausgeübten Haltekraft verwendet werden, wodurch man jederzeit die auf Grund von Leckphänomenen abnehmende Haltekraft zuverlässig und ohne zusätzlichen Aufwand bestimmen kann und gegebenenfalls ein Auffrischen der Haltekräfte veranlasst.

Vorzugsweise können die Anschlusselemente der elektrostatischen Haltevorrichtung berührungslose Anschlusselemente zur berührungslosen Einkopplung von elektrischer Energie für die elektrostatische Haltevorrichtung aufweisen, wodurch man einen Auffrischvorgang der elektrostatischen Haltekräfte ohne unmittelbares Anschließen des Trägers an einen Greifer durchführen kann.

Ferner kann das Trägersubstrat ein Justierfenster zum Justieren der zum Träger weisenden Werkstückoberfläche aufweisen oder für ein Justiersystem transparent sein, wodurch auch die von einem Träger gehaltenen Werkstücke bzw. Produktwafer wie herkömmliche Wafer in herkömmlichen Fertigungsanlagen auch von ihrer Rückseite justiert bzw. ausgerichtet werden können.

Vorzugsweise weist das Trägersubstrat des Trägers ein Halbleitermaterial, ein Quarzmaterial, eine Keramik und/oder einen Schichtaufbau dieser Materialien auf, wobei insbesondere Materialien mit einem gleichen thermischen Ausdehnungskoeffizienten zur Vermeidung von mechanischen Spannungen verwendet werden.

Zur Optimierung der Planarisier- und Haltekräfte sind die Austrittsöffnungen der Bernoulli-Planarisiervorrichtung und der Vakuum-Haltevorrichtung sowie die Elektroden der elektrostatischen Haltevorrichtung gemäß den in den Figuren dargestellten Darstellungen ausgebildet, wobei insbesondere die Bernoulli-Austrittsöffnungen an der Halteoberfläche des Trägers kreisförmig und insbesondere in einem Mittelpunktsbereich ausgebildet sind, während sich die Vakuum-Austrittsöffnungen in einem Randbereich an der Halteoberfläche des Trägers befinden. Die Elektroden der elektrostatischen Haltevorrichtung sind demgegenüber vorzugsweise netzförmig ausgebildet und befinden sich außerhalb des Mittelpunktbereichs bis hin zum Randbereich des Trägers.

Hinsichtlich der Andockstation ist eine Vakuum-Versorgungseinheit zum Versorgen der Vakuum-Haltevorrichtung mit einem Vakuum, eine Bernoulli-Versorgungseinheit zum Versorgen der Bernoulli-Planarisiervorrichtung mit einem Gasstrom und eine Elektrostatikversorgungseinheit zum Versorgen der elektrostatischen Haltevorrichtung mit einem elektrischen Potential vorgesehen, wodurch man über die entsprechenden Anschlusselemente die Vorrichtungen des Trägers ansteuern kann.

Insbesondere die Bernoulli-Versorgungseinheit weist hierbei eine erste Gasstrom-Versorgungseinheit zum Erzeugen eines Bernoulli- und/oder Kühl-Gasstroms auf, wodurch die Bernoulli-Planarisiervorrichtung einerseits als Planarisiervorrichtung zum Planarisieren von eventuell verworfenen Werkstücken und andererseits als Kühlvorrichtung zum Kühlen eines gehaltenen Werkstücks bzw. Produktwafers verwendet werden kann.

Ferner kann die Bernoulli-Versorgungseinheit eine zweite Gasstrom-Versorgungseinheit zum Erzeugen eines Mess-Gasstroms und eine Auswerteeinheit zum Auswerten des Mess-Gasstroms aufweisen, wodurch mittels eines vorzugsweise sehr kleinen Gasstroms wiederum unter Verwendung der Bernoulli-Planarisiervorrichtung im Träger eine aktuell wirkende Haltekraft auf das zu haltende Werkstück sehr einfach und hoch genau erfasst und ausgewertet werden kann.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine vereinfachte perspektivische Ansicht eines Multifunktionsträgers gemäß einem ersten Ausführungsbeispiel;
- Figur 2: eine vereinfachte Draufsicht eines zum Multifunktionsträger gemäß Figur 1 zugehörigen Greifers;
- Figur 3: eine vereinfachte Draufsicht des Multifunktionsträgers sowie des zugehörigen Greifers gemäß Figuren 1 und 2 in einem angedockten Zustand;
- Figur 4: eine vereinfachte Draufsicht eines Multifunktionsträgers gemäß einem zweiten Ausführungsbeispiel;
- Figur 5: eine vereinfachte Teilschnittansicht des Multifunktionsträgers gemäß Figur 4; und
- Figur 6: ein vereinfachtes Blockschaltbild einer Andockstation für den Multifunktionsträger.

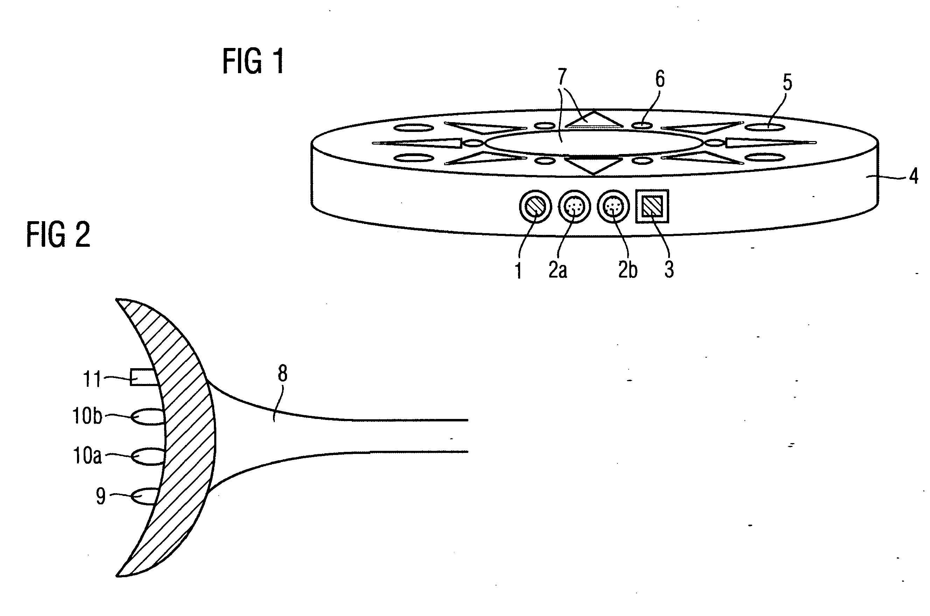

Figur 1 zeigt eine vereinfachte perspektivische Ansicht eines Multifunktionsträgers gemäß einem ersten Ausführungsbeispiel, wie er zur Realisierung einer lösbaren Verbindung zu einem nicht dargestellten Werkstück wie beispielsweise einem ultradünnen und daher verworfenen bzw. verbogenen Produktwafers verwendet wird.

Gemäß Figur 1 weist der Multifunktionsträger ein Trägersubstrat 4 auf, welches vorzugsweise aus einer ebenen Platte mit einer Dicke im Bereich von 2 mm bis 300 µm liegt und gleich groß oder größer als das zu haltende Werkstück ist. Bei Verwendung eines ultradünnen Produktwafers als Werkstück besitzt demzufolge das Trägersubstrat 4 vorzugsweise ebenfalls eine Waferform bzw. die Form eines scheibenförmigen Gegenstands. Es kann jedoch auch eine andere Form verwendet werden.

Die Materialbeschaffenheit des Trägersubstrats 4 ist für die entsprechenden Prozesse vorzugsweise so zu wählen, dass damit Temperaturen von bis zu 600°C erreicht werden können, so wie die Gegenwart flüssiger und gasförmiger Medien nicht zur Beeinträchtigung des Trägersubstrats oder der Träger-Wirkung kommt. Es können jedoch auch Trägermaterialien mit einer Temperaturfestigkeit > 600°C verwendet werden. Vorzugsweise wird daher das Trägersubstrat ein Halbleitermaterial, ein Quarzmaterial, eine Keramik und/oder einen Schichtaufbau bzw. Sandwich-Aufbau dieser Materialien aufweisen. Insbesondere in der Silizium-Halbleiterfertigung bietet sich die Verwendung von herkömmlichen Silizium-Halbleiterwafern mit einer Dicke von 500 bis 700 µm als Trägersubstrat an, da hierbei auch die thermischen Ausdehnungskoeffizienten des Trägersubstrats an das zu haltende Werkstück bzw. den Produktwafer optimal angepasst sind und die verschiedenen Elemente bzw. Vorrichtungen im Trägersubstrat 4 besonders einfach realisiert werden können.

Die grundlegende Idee der vorliegenden Erfindung ist die Konstruktion eines reversibel einsetzbaren und transportablen Multifunktionsträgers, der zunächst Teil eines Roboter-Greifers bzw. einer zugehörigen Andockstation ist und extern zur Realisierung von elektrostatischen Haltekräften, von Vakuum-Haltekräften und/oder von Bernoulli-Kräften versorgt wird.

Demzufolge weist der Multifunktionsträger eine Bernoulli-Planarisiervorrichtung zum Planarisieren des Werkstücks auf dem Trägersubstrat nach dem Bernoulli-Prinzip, eine elektrostatische Haltevorrichtung zum Halten des Werkstücks auf dem Trägersubstrat mittels elektrostatischer Kraft und eine Vakuum-Haltevorrichtung zum Halten des Werkstücks auf dem Trägersubstrat mittels Vakuumkraft auf.

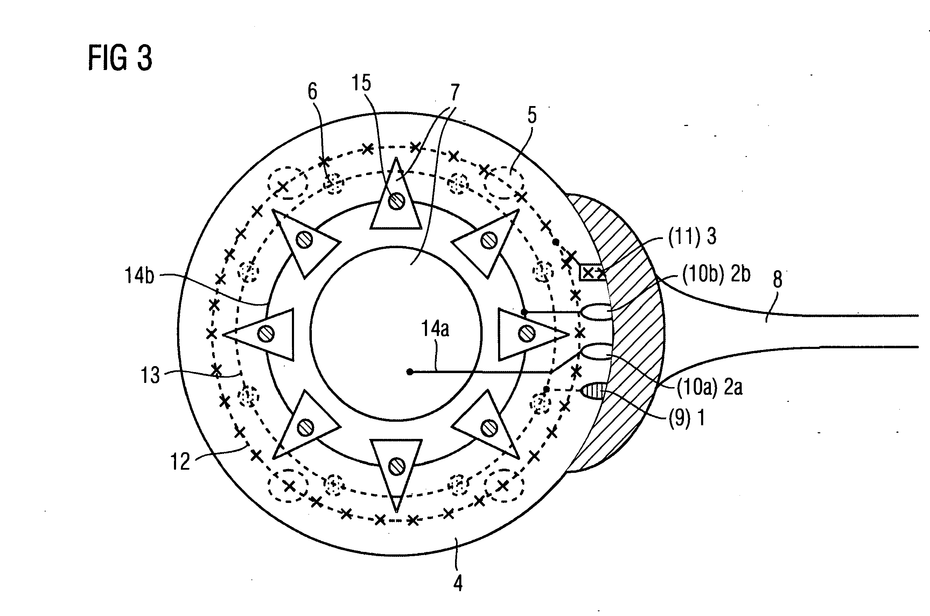

Gemäß Figuren 1 und 3 weist die Bernoulli-Planarisiervorrichtung im Wesentlichen ein Bernoulli-Anschlusselement 1 zum Anschließen eines externen Greifers bzw. einer externen Andockstation an der Stirnseite des Trägersubstrats 4 auf, über die ein für den Bernoulli-Effekt notwendiger Gasstrom zugeführt werden kann. An der Halteoberfläche des Trägersubstrats 4 sind ferner Bernoulli-Austrittsöffnungen 6 ausgebildet, über die der zugeführte Bernoulli-Gasstrom derart gerichtet entweichen kann, dass sich der sogenannte Bernoulli-Effekt ergibt und beispielsweise ein verbogener bzw. verworfener Produktwafer angesaugt und somit planarisiert wird. Zur Verteilung des Bernoulli-Gasstroms ist im Trägersubstrat 4 zwischen dem Bernoulli-Anschlusselement 1 und der Vielzahl von Bernoulli-Austrittsöffnungen 6 ein Bernoulli-Kanalsystem 13 ausgebildet, wie es beispielsweise in Figur 3 schematisch angedeutet ist.

Gemäß Figur 3 sind demzufolge die Bernoulli-Austrittsöffnungen 6 kreisförmig an der Halteoberfläche des Trägersubstrats 4 ausgebildet, wobei sich eine Vielzahl von derartig kreisförmig ausgebildeten Bernoulli-Austrittsöffnungen 6 wiederum kreisförmig entlang des Versorgungskanals bzw. Bernoulli-Kanalsystems 13 angeordnet sind. Auf diese Weise erhält man einen insbesondere für verworfene ultradünne Produktwafer optimalen Ansaugdruck, der sich durch den Bernoulli-Effekt ergibt und eine sehr schonende Planarisierung insbesondere von ultradünnen Produktwafern ermöglicht. Ein Waferbruch ist somit nahezu ausgeschlossen.

Ferner weist auch die im Trägersubstrat 4 ausgebildete Vakuum-Haltevorrichtung ein Vakuum-Anschlusselement 3 beispielsweise ebenfalls an der Stirnseite des Trägersubstrats 4 auf, das wiederum über ein in Figur 3 schematisch angedeutetes Vakuum-Kanalsystem 12 mit Vakuum-Austrittsöffnungen bzw. Vakuum-Pads 5 in Verbindung steht. Auf diese Weise kann durch Anlegen eines Vakuums am Vakuum-Anschlusselement 3 über das Vakuum-Kanalsystem 12 ein Unterdruck an den Vakuum-Austrittsöffnungen 5 erzeugt werden, wodurch das mittels der Bernoulli-Planarisiervorrichtung planarisierte Werkstück mittels Vakuumkräften gehalten und somit gegenüber Querkräften gesichert werden kann.

Darüber hinaus weist der Multifunktionsträger die elektrostatische Haltevorrichtung auf, die wiederum beispielsweise an der Stirnseite des Trägersubstrats 4 elektrostatische Anschlusselemente 2a und 2b in Form von elektrisch leitenden Anschlusskontakten aufweist, die über in Figur 3 schematisch angedeutete elektrisch leitende Leiterbahnen 14a und 14b mit zugehörigen Elektroden 7 verbunden sind.

Zum sicheren Verschließen bzw. Abdichten der Anschlusselemente 1, 2a, 2b und 3 weisen diese Elemente vorzugsweise jeweils ein automatisches Verschlusssystem auf, wie beispielsweise ein Rückschlagventil für die Bernoulliund Vakuum-Anschlusselemente 1 und 3 oder ein elektrisch isolierendes Element für die elektrostatischen Anschlusselemente 2a und 2b. Auf diese Weise kann nicht nur eine Haltekraft konserviert, sondern auch das Eindringen von eventuell in Prozessschritten verwendeten Prozessmaterialien, wie beispielsweise Ätzmitteln, zuverlässig verhindert werden.

Figur 2 zeigt eine vereinfachte Draufsicht eines zum Multifunktionsträger gemäß Figur 1 zugehörigen Greifers 8, wie er beispielsweise an eine (nicht dargestellte) Andockstation angeschaltet sein kann. Dieser Greifer 8 weist beispielsweise bei der in Figur 1 dargestellten stirnseitigen Anordnung der Anschlusselemente eine entsprechende stirnseitige Anordnung von Versorgungselementen 9 bis 11 auf, die in die Anschlusselemente 1 bis 3 des Multifunktionsträgers einpassbar sind. Genauer gesagt weist der Greifer 8 eine der Form des Multifunktionsträgers bzw. des Trägersubstrats 4 angepasste Form auf, wobei über einen Vakuum-Versorgungsanschluss 11 und ein nicht dargestelltes Vakuumversorgungs-Kanalsystem ein Vakuum zugeführt wird. In gleicher Weise kann über einen Bernoulli-Anschluss 9 und ein zugehöriges nicht dargestelltes Bernoulli-Versorgungs-Kanalsystem ein Bernoulli-Gasstrom der Bernoulli-Planarisiervorrichtung zugeführt werden. Die elektrischen Versorgungskontakte 10a und 10b mit ihren zugehörigen nicht dargestellten Versorgungsleitungen versorgen darüber hinaus die elektrostatische Haltevorrichtung mit elektrischer Energie bzw. einer entsprechenden Potentialdifferenz.

Gemäß Figur 3 ist der Multifunktionsträger bzw. das Trägersubstrat 4 zunächst an den Greifer 8 über die Anschlusselemente 1 bis 3 bzw. Versorgungsanschlüsse 9 bis 11 verbunden. Nunmehr kann ein verworfenes Werkstück bzw. ein ultradünner verworfener Produktwafer mit Hilfe dieses aus dem Multifunktionsträger und dem Greifer 8 bestehenden Kombi-Greifers aus der Bernoulli-Planarisiervorrichtung angesaugt bzw. planarisiert werden und anschließend durch Hinzuschalten der Vakuum- oder elektrostatischen Haltevorrichtung gehalten bzw. ge-chuckt werden. Anschließend kann der Multifunktionsträger mit seinem darauf gehaltenen bzw. fixierten Produktwafer vom Greifer getrennt werden, wobei die elektrostatische Haltekraft und/oder die Vakuum-Haltekraft weiterhin vom Multifunktionsträger ausgeübt wird und somit eine Prozessierung von ultradünnen Produktwafern in herkömmlichen Fertigungsanlagen ermöglicht wird. Die elektrostatische Haltevorrichtung weist hierbei einen nicht dargestellten internen Ladungsspeicher und eine entsprechende Isolation auf. Die Vakuum-Haltevorrichtung sollte demzufolge über eine entsprechende Dichtheit verfügen.

Darüber hinaus ist mit einem derartigen Multifunktionsträger auch eine sogenannte Zwangsübergabe des gehaltenen Werkstücks bzw. geträgerten Produktwafers möglich, wobei der Produktwafer, ohne dass er gänzlich von einem Träger getrennt wird, auf einen anderen Multifunktionsträger verbracht und gehalten wird. Die Trennung des Produktwafers vom Trägersubstrat 4 bzw. das Lösen der Verbindung erfolgt beispielsweise durch Umpolung der elektrostatischen Kraft bzw. einer Entladung der elektrostatischen Haltevorrichtung, durch Belüften der Vakuum-Haltevorrichtung und/oder durch Ausschalten bzw. Verringern der Gasströmung in der Bernoulli-Planarisiervorrichtung.

Erfindungsgemäß ist demzufolge der Multifunktionsträger nicht nur ein für herkömmliche Fertigungsanlagen verwendbares Trägersubstrat, das im Wesentlichen die mechanische Stabilität der zu prozessierenden Werkstücke bzw. Produktwafer stabilisiert, sondern kann auch Teil eines Anlagen-Handling-Equipments wie z.B. eines Roboterarms darstellen, wodurch er wie ein handelsüblicher Greifer bzw. wie eine handelsübliche Haltevorrichtung (Chuck) verwendet werden kann. Dadurch ergeben sich außerordentlich kostengünstige Anpassungen bzw. Realisierungsmöglichkeiten bei der Prozessierung insbesondere von ultradünnen Produktwafern. Genauer gesagt kann über passende Adapter durch nachträglichen Einbau eine automatische An- und Entkopplung dieses Systems aus Greifer 8 und Multifunktionsträger an ein Standardequipment durchgeführt werden.

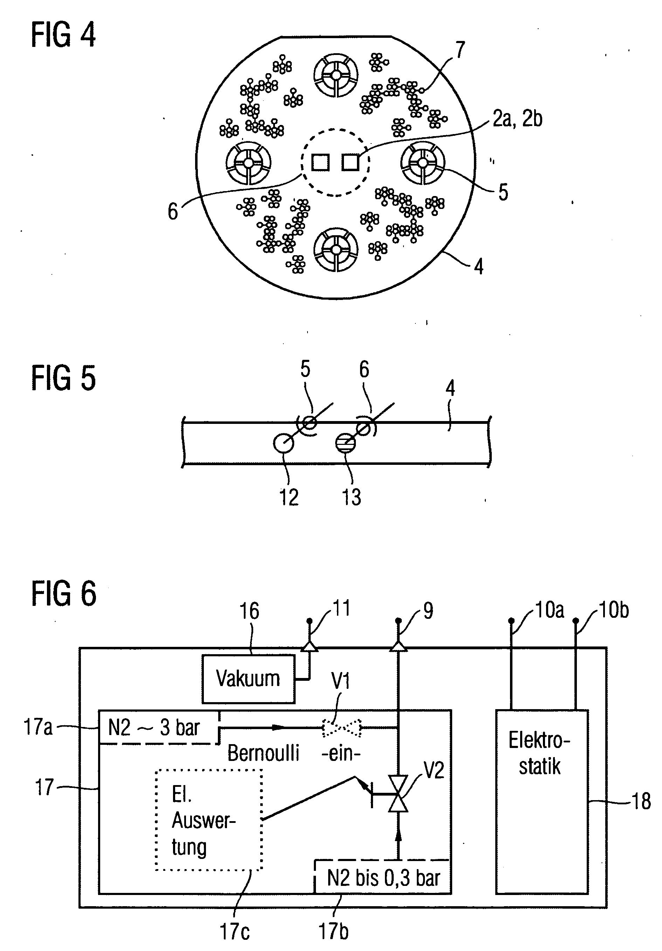

Figur 4 zeigt eine vereinfachte Draufsicht eines Multifunktionsträgers gemäß einem zweiten Ausführungsbeispiel, wobei gleiche Bezugszeichen gleiche oder entsprechende Elemente darstellen, weshalb auf eine wiederholte Beschreibung nachfolgend verzichtet wird.

Gemäß Figur 4 können beispielsweise die elektrostatischen Anschlusselemente 2a und 2b auch an der Rückseite des Trägersubstrats 4 in einem Mittelpunktsbereich ausgebildet werden, wodurch man beispielsweise eine erhöhte mechanische Stabilität bei der Ankopplung des Greifers 8 an den Multifunktionsträger erhält.

Insbesondere zeigt Figur 4 jedoch eine besonders optimierte Anordnung der Bernoulli-Austrittsöffnungen 6, der Vakuum-Pads bzw. -Austrittsöffnungen 5 sowie der elektrostatischen Elektroden 7, die zu einer hervorragenden Funktionalität und insbesondere zu besonders hohen Haltekräften führt.

Demzufolge sind die Bernoulli-Austrittsöffnungen 6 in einem Mittelpunktsbereich des Trägersubstrats 4 kreisförmig ausgebildet, wodurch sich ein besonders wirkungsvoller Bernoulli-Effekt erzielen lässt. Die Vakuum-Austrittsöffnungen 5 sind beispielsweise mit einer Anzahl von 4 in einem Randbereich an der Halteoberfläche des Trägersubstrats 4 ausgebildet, wobei die Elektroden 7 der elektrostatischen Haltevorrichtung in dazwischen liegenden Bereichen zwischen den Vakuum-Austrittsöffnungen 5 und den Bernoulli-Austrittsöffnungen 6 vorzugsweise netzförmig ausgebildet sind. Insbesondere bei dieser in Figur 4 dargestellten Anordnung der Austrittsöffnungen und Elektroden erhält man hervorragende Vakuum- und elektrostatische Haltekräfte.

Da bei ultradünnen Produktwafern sowohl eine Vorderseitenals auch eine Rückseiten-Prozessierung angestrebt wird, weist das Trägersubstrat 4 beispielsweise nicht dargestellte Justierfenster zum Justieren der zum Träger weisenden Werkstückoberfläche auf, oder das Trägersubstrat ist für ein Justiersystem teilweise oder vollständig transparent. Auf diese Weise können auch zum Trägersubstrat 4 weisende Justiermarken am Werkstück bzw. am Produktwafer erfasst und ausgewertet werden, wodurch man eine Ausrichtung bzw. Justage auch von der vom Trägersubstrat 4 üblicherweise abgedeckten Rückseite des Produktwafers durchführen kann.

Figur 5 zeigt eine vereinfachte Teil-Schnittansicht des Trägersubstrats 4 zur Veranschaulichung des Vakuum-Kanalsystems 12 mit zugehöriger Vakuum-Austrittsöffnung 5 und dem Bernoulli-Kanalsystem 13 und zugehörigen Bernoulli-Austrittsöffnungen 6. Obwohl die Austrittsöffnungen gemäß Figur 5 vorzugsweise in einem Winkel von 45° zum jeweiligen Kanalsystem im Trägersubstrat 4 ausgebildet sind, können auch andere Winkel verwendet werden. Insbesondere können die Austrittsöffnungen auch um 90° versetzt sein.

Gemäß einem weiteren nicht dargestellten Ausführungsbeispiel kann der Multifunktionsträger insbesondere für die elektrostatische Haltevorrichtung auch berührungslose Anschlusselemente zur berührungslosen Einkopplung von elektrischer Energie aufweisen, wodurch die in den Figuren 1, 3 und 4 dargestellten elektrostatischen Anschlusselemente 2a und 2b auch isoliert innerhalb des Trägersubstrats ausgebildet sein können. Eine derartige indirekte bzw. kontaktlose Energie-Einkopplung kann beispielsweise magnetisch oder elektromagnetisch erfolgen. Auf diese Weise können insbesondere Auffrischvorgänge wesentlich erleichtert werden, wobei gleichzeitig die Isolationsanforderungen sinken.

Figur 6 zeigt eine vereinfachte Blockdarstellung einer Andockstation, wie sie beispielsweise mit dem Greifer 8 in Verbindung steht. Gleiche Bezugszeichen bezeichnen hierbei wiederum gleiche oder entsprechende Elemente, weshalb auf eine wiederholte Beschreibung nachfolgend verzichtet wird.

Gemäß Figur 6 weist die Andockstation zum Anschließen des Multifunktionsträgers eine Vakuum-Versorgungseinheit 16 zum Erzeugen eines Vakuums und zum Versorgen der Vakuum-Haltevorrichtung über den Vakuum-Versorgungsanschluss 11 mit einem Vakuum auf.

Ferner besitzt die Andockstation eine Elektrostatikversorgungseinheit 18 zum Erzeugen eines elektrischen Potentials und zum Liefern dieses Potentials an die elektrostatische Haltevorrichtung des Multifunktionsträgers über die elektrostatischen Versorgungsanschlüsse 10a und 10b, die ebenfalls berührungslos bzw. kontaktlos zum indirekten Energie-Einkoppeln ausgeführt sein können.

Ferner weist die Andockstation eine Bernoulli-Versorgungseinheit 17 zum Versorgen der Bernoulli-Planarisiervorrichtung mit einem Gasstrom über den Bernoulli-Versorgungsanschluss 9 auf. Die Bernoulli-Versorgungseinheit 17 kann hierbei in drei verschiedenen Betriebsarten arbeiten bzw. drei verschiedene Gasstromversorgungseinheiten aufweisen. Eine erste Gasstrom-Versorgungseinheit 17a liefert hierbei einen Gasstrom wie z.B. N₂ oder Luft mit einem Druck von ca. 3 Bar, wodurch ein Bernoulli-Effekt im Multifunktionsträger erzeugt wird und verbogene bzw. verworfene Produktwafer planarisiert werden können. Andererseits kann diese erste Gasstrom-Versorgungseinheit 17a auch einen Kühl-Gasstrom erzeugen, der nach dem Einschalten der Vakuum- und/oder elektrostatischen Haltevorrichtung während einer Prozessierung wie beispielsweise einer Implantation eine hocheffektive Kühlung des Produktwafers ermöglicht und somit der Wärmeabfuhr dient. Diese beiden Betriebsarten werden beispielsweise über ein Ventil V1 aktiviert.

Ferner kann die Bernoulli-Versorgungseinheit 17 eine weitere Gasstrom-Versorgungseinheit 17b zum Erzeugen eines sehr geringen Mess-Gasstroms im Bereich bis beispielsweise 0,3 Bar (Luft oder N₂) aufweisen, der wiederum über den Bernoulli-Versorgungsanschluss 9 dem Multifunktionsträger und der darin ausgebildeten Bernoulli-Planarisiervorrichtung zugeführt wird. Mittels einer elektrischen Auswerteeinheit 17c kann nunmehr beispielsweise über ein Ventil V2 dieser Mess-Gasstrom ausgewertet werden und daraus eine verbleibende Haltekraft des Multifunktionsträgers auf das zu haltende Werkstück ermittelt werden. In gleicher Weise kann die weitere Gasstrom-Versorgungseinheit 17b auch durch einen an die ersten Gasstrom-Versorgungseinheit 17a angeschalteten Druckminderer oder dergleichen realisiert werden.

Beispielsweise erfasst die Auswerteeinheit 17c einen Gasfluss des Mess-Gasstroms und bestimmt hieraus die Haltekraft, welche durch die Vakuum- und elektrostatischen Haltevorrichtungen auf den Produktwafer ausgeübt werden. Da auf diese Weise die Bernoulli-Austrittsdüsen mit einem schwachen, aber definierten Gasstrom beaufschlagt werden, stellt der Gasfluss ein Maß für die Dichtigkeit oder insbesondere bei ultradünnen Produktwafern die Volumen-Spaltvergrößerung zwischen dem Trägersubstrat und dem gehaltenen Produktwafer dar, wodurch sich Rückschlüsse auf jeweilige Haltekräfte machen lassen. Die Auswerteeinheit 17c kann somit die Standzeit der Haltevorrichtungen bewerten und somit ein Nachladen bzw. Auffrischen rechtzeitig einleiten. Ein Waferbruch wird auf diese Weise weiterhin wesentlich verringert.

Die Erfindung wurde vorstehend anhand eines Halbleiter-Produktwafers und eines zugehörigen Trägerwafers beschrieben. Sie ist jedoch nicht darauf beschränkt und umfasst in gleicher Weise alle weiteren Multifunktionsträger zur Realisierung einer lösbaren Verbindung zu einem beliebigen Werkstück.

## Patentansprüche

1. Multifunktions-Träger zur Realisierung einer lösbaren Verbindung zu einem Werkstück mit:
einem Trägersubstrat (4);
einer Bernoulli-Planarisiervorrichtung (1, 6, 13) zum Planarisieren des Werkstücks auf dem Trägersubstrat (4) nach dem Bernoulli-Prinzip;
einer elektrostatischen Haltevorrichtung (2a, 2b, 14a, 14b, 7) zum Halten des Werkstücks auf dem Trägersubstrat (4) mittels elektrostatischer Kraft; und
einer Vakuum-Haltevorrichtung (3, 5, 12) zum Halten des Werkstücks auf dem Trägersubstrat (4) mittels Vakuumkraft, wobei
die Bernoulli-Planarisiervorrichtung (1, 6, 13), die elektrostatische Haltevorrichtung (2a, 2b, 14a, 14b, 7) und die Vakuum-Haltevorrichtung (3, 5, 12) Anschlusselemente (1, 2a, 2b, 3) zum lösbaren Anschließen an eine Andockstation (8, 9, 10a, 10b, 11) aufweisen.

2. Multifunktionsträger nach Patentanspruch 1,
**dadurch gekennzeichnet, dass** die Anschlusselemente (1, 2a, 2b, 3) ein automatisches Verschlusssystem aufweisen.

3. Multifunktionsträger nach Patentanspruch 1 oder 2,
**dadurch gekennzeichnet, dass** die Bernoulli-Planarisiervorrichtung (1, 6, 13) eine Kühlvorrichtung zum Kühlen des gehaltenen Werkstücks darstellt.

4. Multifunktionsträger nach einem der Patentansprüche 1 bis 3,
**dadurch gekennzeichnet, dass** die Bernoulli-Planarisiervorrichtung (1, 6, 13) eine Haltekraft-Messvorrichtung zum Erfassen einer auf das Werkstück ausgeübten Haltekraft darstellt.

5. Multifunktionsträger nach einem der Patentansprüche 1 bis 4,
**dadurch gekennzeichnet, dass** die Anschlusselemente (2a, 2b) der elektrostatischen Haltevorrichtung berührungslose Anschlusselemente zur berührungslosen Einkopplung von elektrischer Energie für die elektrostatische Haltevorrichtung aufweisen.

6. Multifunktionsträger nach einem der Patentansprüche 1 bis 5,
**dadurch gekennzeichnet, dass** das Trägersubstrat (4) ein Justierfenster zum Justieren der zum Träger weisenden Werkstückoberfläche aufweist.

7. Multifunktionsträger nach einem der Patentansprüche 1 bis 5,
**dadurch gekennzeichnet, dass** das Trägersubstrat (4) für ein Justiersystem transparent ist.

8. Multifunktionsträger nach einem der Patentansprüche 1 bis 7,
**dadurch gekennzeichnet, dass** das Trägersubstrat (4) ein Halbleitermaterial, ein Quarzmaterial, eine Keramik und/oder einen Schichtaufbau dieser Materialien aufweist.

9. Multifunktionsträger nach einem der Patentansprüche 1 bis 8,
**dadurch gekennzeichnet, dass** die Bernoulli-Planarisiervorrichtung Bernoulli-Austrittsöffnungen (6) aufweist, die an der Halteoberfläche des Trägers (4) kreisförmig ausgebildet sind.

10. Multifunktionsträger nach Patentanspruch 9,
**dadurch gekennzeichnet, dass** die Bernoulli-Austrittsöffnungen (6) in einem Mittelpunktsbereich des Trägers (4) ausgebildet sind.

11. Multifunktionsträger nach einem der Patentansprüche 1 bis 10,
**dadurch gekennzeichnet, dass** die Vakuum-Haltevorrichtung Vakuum-Austrittsöffnungen (5) aufweist, die in einem Randbereich an der Halteoberfläche des Trägers (4) ausgebildet sind.

12. Multifunktionsträger nach einem der Patentansprüche 1 bis 11,
**dadurch gekennzeichnet, dass** die elektrostatische Haltevorrichtung Elektroden (7) aufweist, die im Träger (4) netzförmig ausgebildet sind.

13. Multifunktionsträger nach Patentanspruch 12,
**dadurch gekennzeichnet, dass** die Elektroden (7) außerhalb eines Mittelpunktbereichs des Trägers (4) bis in seinen Randbereich hinein ausgebildet sind.

14. Multifunktionsträger nach einem der Patentansprüche 1 bis 13,
**dadurch gekennzeichnet, dass** das Werkstück einen ultradünnen Produktwafer darstellt.

15. Andockstation zum Anschließen eines Multifunktionsträgers nach einem der Patentansprüche 1 bis 14,
**gekennzeichnet durch**
eine Vakuum-Versorgungseinheit (16) zum Versorgen der Vakuum-Haltevorrichtung mit einem Vakuum;
eine Bernoulli-Versorgungseinheit (17) zum Versorgen der Bernoulli-Planarisiervorrichtung mit einem Gasstrom; und eine Elektrostatikversorgungseinheit (18) zum Versorgen der elektrostatischen Haltevorrichtung mit einem elektrischen Potential.

16. Andockstation nach Patentanspruch 15,
**dadurch gekennzeichnet, dass** die Bernoulli-Versorgungseinheit (17) eine erste Gasstromversorgungseinheit (17a) zum Erzeugen eines Bernoulli- oder Kühl-Gasstroms aufweist.

17. Andockstation nach Patentanspruch 15 oder 16,
**dadurch gekennzeichnet, dass** die Bernoulli-Versorgungseinheit (17) eine Mess-Gasstrom-Versorgungseinheit (17b) zum Erzeugen eines Mess-Gasstroms und eine Auswerteeinheit (17c) zum Auswerten des Mess-Gasstroms aufweist.

18. Andockstation nach Patentanspruch 17,
**dadurch gekennzeichnet, dass** die Auswerteeinheit (17c) einen Gasfluss des Mess-Gasstroms erfasst und daraus eine verbleibende Haltekraft des Multifunktionsträgers ermittelt.

19. Andockstation nach einem der Patentansprüche 15 bis 18,
**dadurch gekennzeichnet, dass** er einen Träger-Greifer (8) mit Träger-Anschlusselementen (9, 10a, 10b, 11) aufweist.

## Claims

1. Multifunctional carrier for creating a releasable connection with a workpiece, comprising:
a carrier substrate (4);
a Bernoulli planarizing device (1, 6, 13) for planarizing the workpiece on the carrier substrate (4) on the basis of the Bernoulli principle;
an electrostatic holding device (2a, 2b, 14a, 14b, 7) for holding the workpiece on the carrier substrate (4) by means of electrostatic force; and
a vacuum holding device (3, 5, 12) for holding the workpiece on the carrier substrate (4) by means of vacuum force,
wherein
the Bernoulli planarizing device (1, 6, 13), the electrostatic holding device (2a, 2b, 14a, 14b, 7) and the vacuum holding device (3, 5, 12) have connecting elements (1, 2a, 2b, 3) for releasably connecting to a docking station (8, 9, 10a, 10b, 11).

2. Multifunctional carrier according to Patent Claim 1, **characterized in that** the connecting elements (1, 2a, 2b, 3) have an automatic closure system.

3. Multifunctional carrier according to Patent Claim 1 or 2, **characterized in that** the Bernoulli planarizing device (1, 6, 13) has a cooling device for cooling the held workpiece.

4. Multifunctional carrier according to one of Patent Claims 1 to 3, **characterized in that** the Bernoulli planarizing device (1, 6, 13) represents a holding-force measuring device for recording the holding force exerted on the workpiece.

5. Multifunctional carrier according to one of Patent Claims 1 to 4, **characterized in that** the connecting elements (2a, 2b) of the electrostatic holding device comprise contactless connecting elements for the contactless coupling in of electrical energy for the electrostatic holding device.

6. Multifunctional carrier according to one of Patent Claims 1 to 5, **characterized in that** the carrier substrate (4) has an adjusting window for adjusting the surface of the workpiece that is facing the carrier.

7. Multifunctional carrier according to one of Patent Claims 1 to 5, **characterized in that** the carrier substrate (4) is transparent for an adjusting system.

8. Multifunctional carrier according to one of Patent Claims 1 to 7, **characterized in that** the carrier substrate (4) comprises a semiconductor material, a quartz material, a ceramic and/or a layered structure of these materials.

9. Multifunctional carrier according to one of Patent Claims 1 to 8, **characterized in that** the Bernoulli planarizing device has Bernoulli outlet openings (6), which are of a circular form at the holding surface of the carrier (4).

10. Multifunctional carrier according to Patent Claim 9, **characterized in that** the Bernoulli outlet openings (6) are formed in the region of the centre point of the carrier (4).

11. Multifunctional carrier according to one of Patent Claims 1 to 10, **characterized in that** the vacuum holding device has vacuum outlet openings (5), which are formed in an edge region on the holding surface of the carrier (4).

12. Multifunctional carrier according to one of Patent Claims 1 to 11, **characterized in that** the electrostatic holding device has electrodes (7), which are formed in the carrier (4) in the manner of a network.

13. Multifunctional carrier according to Patent Claim 12, **characterized in that** the electrodes (7) are formed outside a region of the centre point of the carrier (4) into its edge region.

14. Multifunctional carrier according to one of Patent Claims 1 to 13, **characterized in that** the workpiece represents an ultra-thin product wafer.

15. Docking station for connecting a multifunctional carrier according to one of Patent Claims 1 to 14, **characterized by** a vacuum supply unit (16) for supplying the vacuum holding device with a vacuum; a Bernoulli supply unit (17) for supplying the Bernoulli planarizing device with a gas stream; and an electrostatic supply unit (18) for supplying the electrostatic holding device with an electric potential.

16. Docking station according to Patent Claim 15, **characterized in that** the Bernoulli supply unit (17) has a first gas stream supply unit (17a) for generating a Bernoulli or cooling gas stream.

17. Docking station according to Patent Claim 15 or 16, **characterized in that** the Bernoulli supply unit (17) has a measuring gas stream supply unit (17b) for generating a measuring gas stream and an evaluation unit (17c) for evaluating the measuring gas stream.

18. Docking station according to Patent Claim 17, **characterized in that** the evaluation unit (17c) records a gas flow of the measuring gas stream and determines from it a permanent holding force of the multifunctional carrier.

19. Docking station according to one of Patent Claims 15 to 18, **characterized in that** it has a carrier gripper (8) with carrier connecting elements (9, 10a, 10b, 11).

## Revendications

1. Support multifonctionnel pour réaliser une liaison amovible à une pièce comprenant :
un substrat (4) de support ;
un dispositif (1, 6, 13) de planarisation de Bernoulli pour planariser la pièce sur le substrat (4) de support suivant le principe de Bernoulli ;
un dispositif (2a, 2b, 14a, 14b, 7) électrostatique de maintien pour maintenir la pièce sur le substrat (4) de support au moyen d'une force électrostatique ; et
un dispositif (3, 5, 12) de maintien par le vide pour maintenir la pièce sur le substrat (4) de support au moyen d'une force de vide,
dans lequel
le dispositif (1, 6, 13) de planarisation de Bernoulli, le dispositif (2a, 2b, 14a, 14b, 7) électrostatique de maintien et le dispositif (3, 5, 12) de maintien par le vide ont des éléments (1, 2a, 2b, 3) de raccordement pour le raccordement amovible à un poste (8, 9, 10a, 10b, 11) d'accostage.

2. Support multifonctionnel suivant la revendication 1,
**caractérisé en ce que** les éléments (1, 2a, 2b, 3) de raccord ont un système automatique de fermeture.

3. Support multifonctionnel suivant la revendication 1 ou 2,
**caractérisé en ce que** le dispositif (1, 6, 13) de planarisation de Bernoulli constitue un dispositif de refroidissement pour refroidir la pièce maintenue.

4. Support multifonctionnel suivant l'une des revendications 1 à 3,
**caractérisé en ce que** le dispositif (1, 6, 13) de planarisation de Bernoulli constitue un dispositif de mesure de force de maintien pour détecter une force de maintien appliquée à la pièce.

5. Support multifonctionnel suivant l'une des revendications 1 à 4,
**caractérisé en ce que** les éléments (2a, 2b) de raccord du dispositif électrostatique de maintien ont des éléments de raccord sans contact pour l'injection sans contact d'énergie électrique pour le dispositif électrostatique de maintien.

6. Support multifonctionnel suivant l'une des revendications 1 à 5,
**caractérisé en ce que** le substrat (4) de support a une fenêtre d'ajustement pour l'ajustement de la surface de la pièce tournée vers le support.

7. Support multifonctionnel suivant l'une des revendications 1 à 5,
**caractérisé en ce que** le substrat (4) de support est transparent pour un système d'ajustement.

8. Support multifonctionnel suivant l'une des revendications 1 à 7,
**caractérisé en ce que** le substrat (4) de support comprend un matériau semi-conducteur, un matériau en quartz, une céramique et/ou une structure stratifiée de ces matériaux.

9. Support multifonctionnel suivant l'une des revendications 1 à 8,
**caractérisé en ce que** le dispositif de planarisation de Bernoulli a des ouvertures (6) de sortie de Bernoulli, qui sont sous la forme de cercles à la surface de maintien du support (4).

10. Support multifonctionnel suivant la revendication 9
**caractérisé en ce que** les ouvertures (6) de sortie de Bernoulli sont formées dans une partie centrale du support (4).

11. Support multifonctionnel suivant l'une des revendications 1 à 10,
**caractérisé en ce que** le dispositif de maintien par le vide a des ouvertures (5) de sortie du vide, qui sont formées dans une partie marginale, à la surface de maintien du support (4).

12. Support multifonctionnel suivant l'une des revendications 1 à 11,
**caractérisé en ce que** le dispositif électrostatique de maintien a des électrodes (7) qui sont formées sous forme de réseau dans le support (4).

13. Support multifonctionnel suivant la revendication 12,
**caractérisé en ce que** les électrodes (7) sont formées à l'extérieur d'une partie centrale du support (4) jusque dans sa partie marginale.

14. Support multifonctionnel suivant l'une des revendications 1 à 13,
**caractérisé en ce que** la pièce constitue une tranche de produit ultramince.

15. Poste d'accostage pour le raccordement d'un support multifonctionnel suivant l'une des revendications 1 à 14,
**caractérisé par**
un groupe (16) d'alimentation en vide pour alimenter en vide le dispositif de maintien par le vide ;
un groupe (17) d'alimentation de Bernoulli pour alimenter le dispositif de planarisation de Bernoulli en un courant gazeux ; et
un groupe (18) électrostatique d'alimentation pour alimenter en potentiel électrique le dispositif électrostatique de maintien.

16. Poste d'accostage suivant la revendication 15,
**caractérisé en ce que** le groupe (17) d'alimentation de Bernoulli a un premier groupe (17a) d'alimentation en courant gazeux pour produire un courant gazeux de Bernoulli ou de refroidissement.

17. Poste d'accostage suivant la revendication 15 ou 16,
**caractérisé en ce que** le groupe (17) d'alimentation de Bernoulli a un groupe (17b) d'alimentation en courant gazeux de mesure pour produire un courant gazeux de mesure et un groupe (17c) d'exploitation pour exploiter le courant gazeux de mesure.

18. Poste d'accostage suivant la revendication 17,
**caractérisé en ce que** le groupe (17c) d'exploitation détecte un flux du courant gazeux de mesure et en détermine une force de maintien restante du support multifonctionnel.

19. Poste d'accostage suivant l'une des revendications 15 à 18,
**caractérisé en ce qu'**il a un préhenseur (8) de support ayant des éléments (9, 10a, 10b, 11) de raccord de support.
